# EUROPÄISCHE PATENTSCHRIFT

(11) **EP 2 558 615 B1**
(45) Veröffentlichungstag und Bekanntmachung des Hinweises auf die Patenterteilung: **18.03.2015**
(21) Anmeldenummer: 11712843.9
(22) Anmeldetag: 05.04.2011
(51) Int. Cl.: C23C 16/52, H01L 21/00

(54) **VORRICHTUNG UND VERFAHREN ZUM GLEICHZEITIGEN ABSCHEIDEN MEHRERER HALBLEITERSCHICHTEN IN MEHREREN PROZESSKAMMERN**
DEVICE AND METHOD FOR SIMULTANEOUSLY PRECIPITATING A PLURALITY OF SEMICONDUCTOR LAYERS IN A PLURALITY OF PROCESS CHAMBERS
DISPOSITIF ET PROCÉDÉ POUR DÉPOSER SIMULTANÉMENT PLUSIEURS COUCHES SEMI-CONDUCTRICES DANS PLUSIEURS CHAMBRES DE PROCÉDÉ

(30) Priorität: 16.04.2010 DE 102010016471
(43) Veröffentlichungstag der Anmeldung: 20.02.2013
(73) Patentinhaber: Aixtron SE, 52134 Herzogenrath (DE)
(72) Erfinder: KÄPPELER, Johannes, 52146 Würselen (DE); BOYD, Adam, B-4720 Kelmis (BE)
(74) Vertreter: Grundmann, Dirk
(86) Internationale Anmeldenummer: PCT/EP2011/055248
(87) Internationale Veröffentlichungsnummer: WO 2011/128226

(56) Entgegenhaltungen:
- WO-A2-2008/028082
- JP-A- 2004 063 925
- US-A1- 2003 045 960
- US-A1- 2003 049 376
- US-A1- 2004 123 806
- US-B1- 6 176 667

## Beschreibung

Die Erfindung betrifft ein Verfahren zum Abscheiden von mindestens einer Schicht, insbesondere einer Halbleiterschicht auf einer Vielzahl von Substraten, wobei in einer Beschichtungsvorrichtung mehrere Prozesskammern von einer gemeinsamen Gasversorgungseinrichtung mit Prozessgasen versorgt werden, die jeweils von einem Gaseinlassorgan in die Prozesskammer eingeleitet werden, in der sich auf einem Suszeptor ein oder mehrere der zu beschichtenden Substrate befinden, wobei die vom Abstand einer Prozesskammerdecke und einem Prozesskammerboden gebildete Prozesskammerhöhe variierbar ist und einen Einfluss auf die Wachstumsrate der Schicht hat.

Die Erfindung betrifft darüber hinaus eine Vorrichtung zum Abscheiden von jeweils mindestens einer Schicht, insbesondere Halbleiterschicht auf eine Vielzahl von Substraten, mit einem Reaktorgehäuse, das eine Vielzahl von Prozesskammern aufweist, wobei jede Prozesskammer ein Gaseinlassorgan zum Einleiten von Prozessgasen in die Prozesskammer und einen Suszeptor zur Aufnahme mindestens eines Substrates aufweist und wobei die vom Abstand einer Prozesskammerdecke und einem Prozesskammerboden gebildete Prozesskammerhöhe von einem Stellglied einstellbar ist, und mit einer gemeinsamen Gasversorgungseinrichtung, um die Prozesskammern mit dem Prozessgas zu versorgen.

Die DE 10 2005 056 323 A1 beschreibt eine Vorrichtung, die ein Reaktorgehäuse aufweist, in dem eine Mehrzahl von Prozesskammern angeordnet sind. Die Vorrichtung besitzt darüber hinaus eine Gasversorgungseinheit zum Bereitstellen verschiedener Trägergase und Prozessgase. Die Prozessgase werden individuell dosiert über Gaseinlassorgane in die einzelnen Prozesskammern eingeleitet. Zum Zwecke des Ent- bzw. Beladens sind dort die Suszeptoren absenkbar, wobei die Höhe der Prozesskammer sich vergrößert. In den Prozesskammern findet ein MOCVD-Prozess statt.

Die DE 10217 806 A1 beschreibt eine Vorrichtung zur Durchführung eines MOCVD-Prozesses, bei der die Prozessgase ebenso wie bei der zuvor geschilderten Prozesskammer durch ein duschkopfartiges Prozessgaseinlassorgan in die Prozesskammer eingeleitet werden. Zur Beeinflussung der Wachstumsparameter der dort abgeschiedenen Schichten kann die Höhe der Prozesskammer beeinflusst werden. Dies erfolgt mittels Stellgliedern, die den Suszeptor und eine daran befestigte Heizeinrichtung auf und ab verlagern kann.

Die DE 10 2004 007 984 A1 beschreibt einen CVD-Reaktor, bei dem bestimmte Schichtparameter optisch während des Schichtwachstums bestimmt werden können. Hierzu befinden sich in einer rückwärtigen Wand eines Gaseinlassorgans reihenförmig angeordnete Sensoren, wobei die optische Wegstrecke vom Substrat zum Sensor durch eine Gasaustrittsöffnung des Gaseinlassorgans verläuft.

US20030049376 A1 beschreibt einen CVD Reaktor mit zwei Kammern bei dem die Prozesskammerhöhe variiert wird.

In einer gattungsgemäßen Vorrichtung werden synchron in mehreren Prozesskammern identische Wachstumsprozesse durchgeführt.

Der Erfindung liegt die Aufgabe zugrunde, Maßnahmen anzugeben, damit die Schichtdicken der so abgeschiedenen Schichten auf allen Substraten im Wesentlichen identisch ist.

Da die Prozesskammern eines derartigen Multi-Prozesskammer-Reaktors graduelle Unterschiede aufweisen, die zu unterschiedlichem Schichtwachstum führen können, müssen bei jeder Prozesskammer individuelle Maßnahmen ergriffen werden, um das Schichtwachstum zu korrigieren. Experimente haben ergeben, dass die Wachstumsrate nicht nur von der Zusammensetzung und Konzentration der Prozessgase, sondern auch von der Höhe der Prozesskammer abhängt. Die erfindungsgemäße Lösung der oben genannten Aufgabe besteht somit darin, dass während des Schichtwachstums kontinuierlich bzw. in insbesondere kurzen Intervallen in jeder Prozesskammer an zumindest einem Substrat die Schichtdicke gemessen wird. Mittels eines Reglers und eines Stellgliedes wird die Prozesskammer höhe während des Wachstums variiert. Die Variation erfolgt mit dem Ziel, dass in den Prozesskammern Schichten mit gleicher Schichtdicke abgeschieden werden. Die Wachstumsrate nimmt mit steigender Prozesskammerhöhe ab. Wird beispielsweise während des Abscheideprozesses von einer Schichtdickenmesseinrichtung in einer Prozesskammer festgestellt, dass die dort abgeschiedene Schicht momentan dicker ist, als die Schichten, die in den übrigen Prozesskammern abgeschieden werden, so wird während des Wachstumsprozesses von dem Regler das Stellglied, mit dem die Höhe der Prozesskammer eingestellt werden kann, mit einem entsprechenden Änderungswert beaufschlagt, so dass beispielweise der Suszeptor um einen gewissen Betrag abgesenkt wird, so dass sich die Prozesskammerhöhe vergrößert. Alternativ dazu kann der Regler auch an die Stellglieder der übrigen Prozesskammern die Anweisung geben, die Prozesskammerhöhe zu vermindern, damit dort die Wachstumsrate ansteigt. Die Auswahl der einen oder der anderen Alternative erfolgt anhand der aktuellen Prozesskammerhöhe. Diese soll ein vorgegebenes Minimum nicht unterschreiten und ein vorgegebenes Maximum nicht überschreiten.

In einer bevorzugten Weiterbildung der Erfindung wird die Schichtdicke an verschiedenen Stellen in der Prozesskammer und insbesondere in verschiedenen Radialabständen von einem Zentrum der im Wesentlichen rotationssymmetrischen Prozesskammer ermittelt. Dies erfolgt vorzugsweise mittels einer optischen Messeinrichtung, wie sie aus der DE 10 2004 007 984 A1 bekannt ist, nämlich mit einem Fotodioden-Array, welches an der Rückwand einer Kammer eines Gaseinlassorgans angeordnet ist, so dass die optische Wegstrecke durch jeweils eine Gasaustrittsöffnung der Unterseite des Gaseinlassorgans verläuft. Die Schichtdeckenmesseinrichtung kann aber auch außerhalb des Reaktorgehäuses angeordnet sein. Die Messeinrichtung kann über einen Lichtleiter mit der Prozesskammer verbunden sein. Es ist aber auch möglich, dass das Licht zur Ermittlung der Schichtdicke durch ein Rohr auf die Sensoroberfläche fällt.

Die erfindungsgemäße Vorrichtung zeichnet sich durch eine Gasversorgungseinrichtung aus, die jede einzelne Prozesskammer mit einem Prozessgas versorgt. Es können individuelle Dosiereinheiten vorgesehen sein, die jeweils ein Gaseinlassorgan mit Prozessgas versorgen. Bei dem Gaseinlassorgan handelt es sich um einen duschkopfartigen Körper mit an der Unterseite angeordneten Gasaustrittsöffnungen, durch die das Prozessgas, bei dem es sich bevorzugt um eine metalorganische III-Komponente und ein V-Hydrid handelt, in die Prozesskammer eingeleitet werden. Während der Deckel der Prozesskammer von der Unterseite des Gaseinlassorgans gebildet wird, wird der Boden der Prozesskammer von der Oberseite eines Suszeptors gebildet. Auf dem Suszeptor liegen ein oder mehrere zu beschichtende Substrate auf. Um die im Wesentlichen kreisrunde Prozesskammer erstreckt sich ein Gasauslassring, der über eine Gasauslassleitung mit einem Druckregler verbunden ist. Die Gesamtheit der Prozesskammern ist an einer gemeinschaftlichen Vakuumpumpe angeschlossen. Unterhalb des aus Graphit bestehenden Suszeptors befindet sich eine Heizeinrichtung, um den Suszeptor auf eine Prozesstemperatur zu heizen. Mittels eines Stellgliedes kann die Höhe des Suszeptors und damit die Höhe der Prozesskammer eingestellt werden. Auf der Rückseite des Gaseinlassorgans befindet sich das oben erwähnte Schichtdickenmessgerät, welches durch die Gasaustrittsöffnung hindurch optisch die Schichtdicke während des Prozesses misst. Das Schichtdickenmessgerät kann aber auch außerhalb des Reaktorgehäuses vorgesehen sein. Es kann dann beispielsweise mit Hilfe eines Lichtleiters mit der Prozesskammer verbunden sein. Es ist aber auch möglich, dass die optische Verbindung zur Prozesskammer über ein Rohr erfolgt. Letzteres kann auch mit einem Inertgas gespült sein. Es ist ein Regler vorgesehen. Dieser erhält von der schichtdicken Messeinrichtung Eingangsmessgrößen. Der Regler vergleicht die momentan gemessenen Schichtdicken miteinander, um die Stellglieder mit Stellwerten zu versorgen, um die Prozesskammerhöhe dahingehend zu variieren, dass Schichten mit gleicher Schichtdicke abgeschieden werden.

Ein Ausführungsbeispiel der Erfindung wird nachfolgend anhand beigefügter Zeichnungen erläutert. Es zeigen:

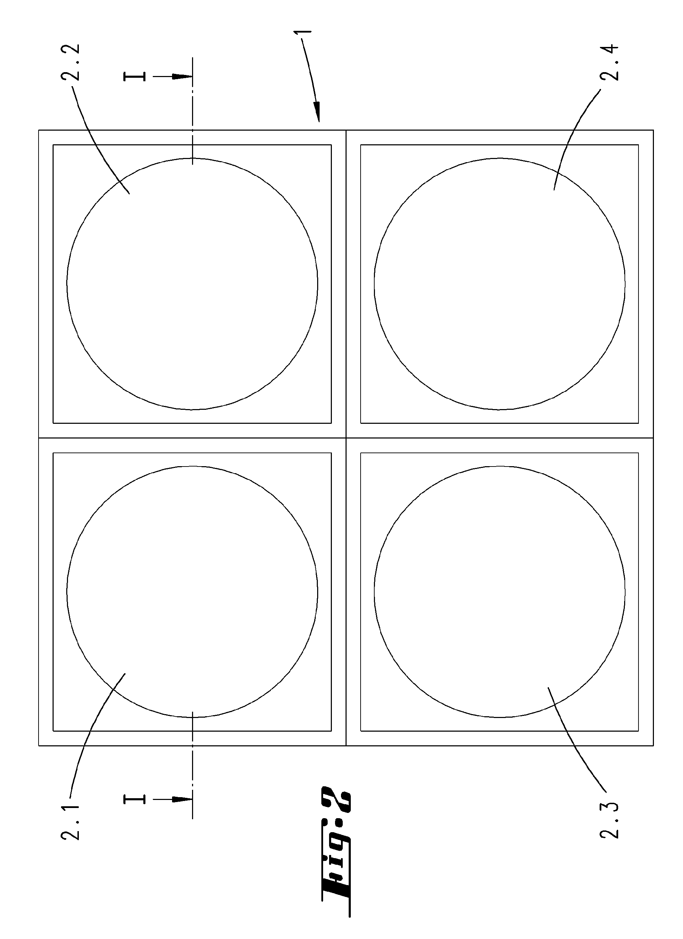

- Fig. 1: in schematischer Darstellung einen Querschnitt durch einen Multiprozesskammerreaktor entlang der Schnittlinie I-I in Fig. 2,
- Fig. 2: einen Schnitt entlang der Schnittlinie II-II in Fig. 1,
- Fig. 3: eine Darstellung gemäß Fig. 1 eines weiteren Ausführungsbeispiels, und
- Fig. 4: die gemessene Abhängigkeit der Wachstumsrate von der Prozesskammerhöhe H bei verschiedenen Totaldrucken.

In dem aus Edelstahl bestehenden Reaktorgehäuse 1 sind insgesamt vier Prozesskammern 2.1, 2.2, 2.3, 2.4 ausgebildet. Jede der vier Prozesskammern 2.1, 2.2, 2.3, 2.4 wird individuell über eine Gaszuleitung 13 mit Prozessgasen versorgt. In den Figuren ist lediglich eine Leitung 13 je Prozesskammer eingezeichnet. Es können auch mehrere Zuleitungen 13 sein, die jedoch alle mit einer gemeinsamen Gasversorgungseinrichtung 11 verbunden sind. Die Gasversorgungseinrichtung 11 besitzt Ventile und Massenflussmessgeräte, um die Prozessgase individuell zu dosieren.

In jeder der insgesamt vier Prozesskammern des Reaktors 1 befindet sich ein Einlassorgan 3, welches die Form eines Duschkopfs besitzt. Es besitzt eine rückwärtige Platte, an der der optische Sensor 17 und eine Schichtdickenmesseinrichtung 10 angebracht sind, und in einem Abstand dazu eine vorderseitige Platte, in der sich eine Vielzahl von Gasaustrittsöffnungen 18 befinden. Durch einige der Gasaustrittsöffnungen 18 verläuft die optische Wegstrecke der optischen Sensoren 17. In die Kammer zwischen Rückenplatte und Frontplatte des Gaseinlassorgans 3 wird das Prozessgas eingelassen, welches durch die Gasaustrittsöffnung 18 in die Prozesskammer 2 einströmt.

Unterhalb der von der Unterseite des Gaseinlassorgans 3 gebildeten Prozesskammerdecke 8 befindet sich ein Suszeptor 4, der mit seiner Oberseite einen sich parallel zur Prozesskammerdecke 8 erstreckenden Prozesskammerboden 9 ausbildet. Auf dem Suszeptor 4 liegt ein Substrat 5, welches beschichtet wird. Es ist aber auch möglich, auf die Suszeptor-Oberfläche mehrere Substrate zu legen, die gleichzeitig beschichtet werden. Der Suszeptor 4 kann auch um eine Zentralachse drehangetrieben werden.

Unterhalb des Suszeptors befindet sich eine Heizung 16, um den Suszeptor auf Prozesstemperatur aufzuheizen.

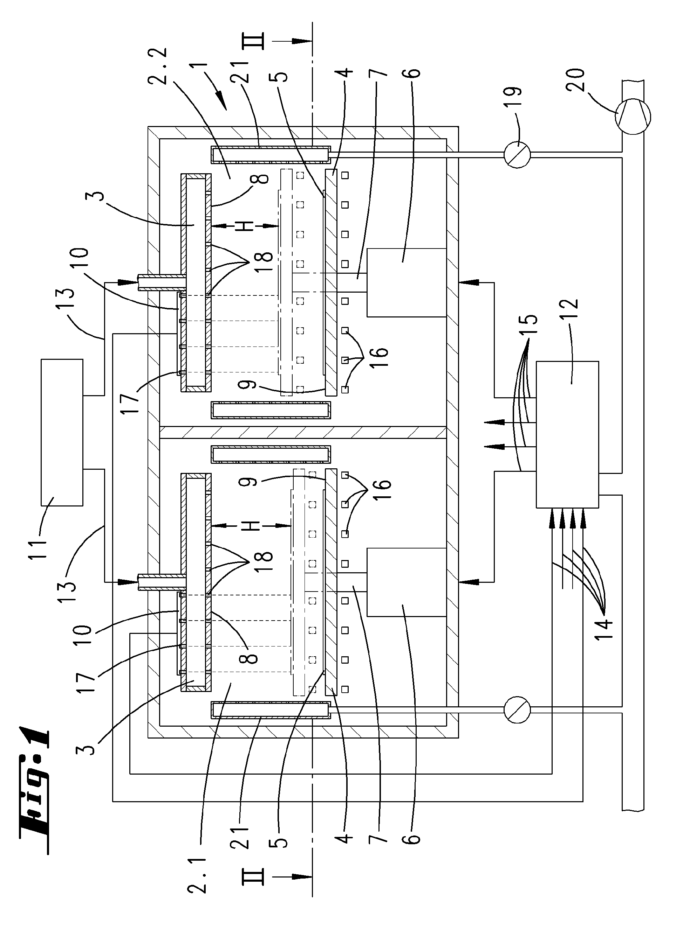

Es ist ein Träger 7 vorgesehen, der die Heizung 16 und der den Suszeptor 4 trägt. Mittels eines Stellgliedes 6 kann der Träger 7 in der Höhe verlagert werden, so dass damit der Suszeptor 4 zusammen mit der Heizung 16 aus der in der Fig. 1 mit durchgezogenen Strichen dargestellten Position in die gestrichelt dargestellte Position angehoben werden kann. Dies hat zur Folge, dass sich die Höhe H der Prozesskammer, die dem Abstand zwischen Prozesskammerdecke 8 und Prozesskammerboden 9 entspricht, vermindert wird.

Die Seitenwand der Prozesskammer 2 wird von einem Gasauslassring 21 gebildet, der über eine Gasableitung mit einem Druckregler 19 verbunden ist. Beim Druckregler 19 kann es sich um ein Drosselventil handeln. Sämtliche Drosselventile der Prozesskammern 2 sind mit einer gemeinsamen Vakuumpumpe 20 verbunden.

Es ist ein elektronischer Regler 12 vorgesehen. Dieser erhält von jeder Schichtdickenmesseinrichtung 10 einen Eingangswert über eine Datenleitung 14, der der augenblicklich gemessenen Schichtdicke entspricht. Besitzt die Messeinrichtung 10 eine Vielzahl von optischen Sensoren 17, erhält der Regler 12 eine entsprechende Vielzahl von Daten. Der Regler 12 bestimmt dann zu jeder Prozesskammer eine mittlere Schichtdicke.

Der Regler 12 vergleicht die Schichtdicken untereinander und stellt Abweichungen fest. Stellt der Regler 12 fest, dass in einer Prozesskammer die mittlere Schichtdicke geringer ist, als in den anderen Prozesskammern oder dass in einer der Prozesskammern die mittlere Schichtdicke größer ist, als in den anderen Prozesskammern, so ergreift er geeignete Maßnahmen, die darin bestehen, dass in einer oder mehreren Prozesskammern der Suszeptor 4 zusammen mit der Heizung 16 angehoben oder abgesenkt wird. Die diesbezüglichen Stellwerte werden über Datenleitungen 15 an das jeweilige Höheneinstellglied 6 geleitet.

In einem typischen MOCVD-Prozess, bei dem im Niedrigdruckbereich durch das Gaseinlassorgan 3 eine III-metallorganische Komponente zusammen mit Wasserstoff als Trägergas und ein V-Hydrid eingeleitet wird, nimmt die Wachstumsrate der III-V-Schicht ab, wenn sich die Prozesskammerhöhe H erhöht. Durch eine Verlagerung des Suszeptors 4 nach oben oder unten kann somit die Wachstumsrate modifiziert werden. Dies erfolgt insgesamt so, dass in jeder der Prozesskammern 2.1 bis 2.4 Schichten mit im Wesentlichen identischer Schichtdicke abgeschieden werden. Die Regelung erfolgt derart, dass in den einzelnen Prozesskammern 2.1 bis 2.4 Wachstumsprozesse stattfinden, die durch eine im Wesentlichen identische mittlere Wachstumsrate gekennzeichnet sind. Weichen während des Abscheideprozesses die aktuellen Wachstumsraten in den Prozesskammern 2.1 bis 2.4 voneinander ab, so werden die Prozesskammerhöhen verändert. Dabei kann bewusst eine Überkompensation stattfinden, um eine Differenz in den Schichtdicken auszugleichen.

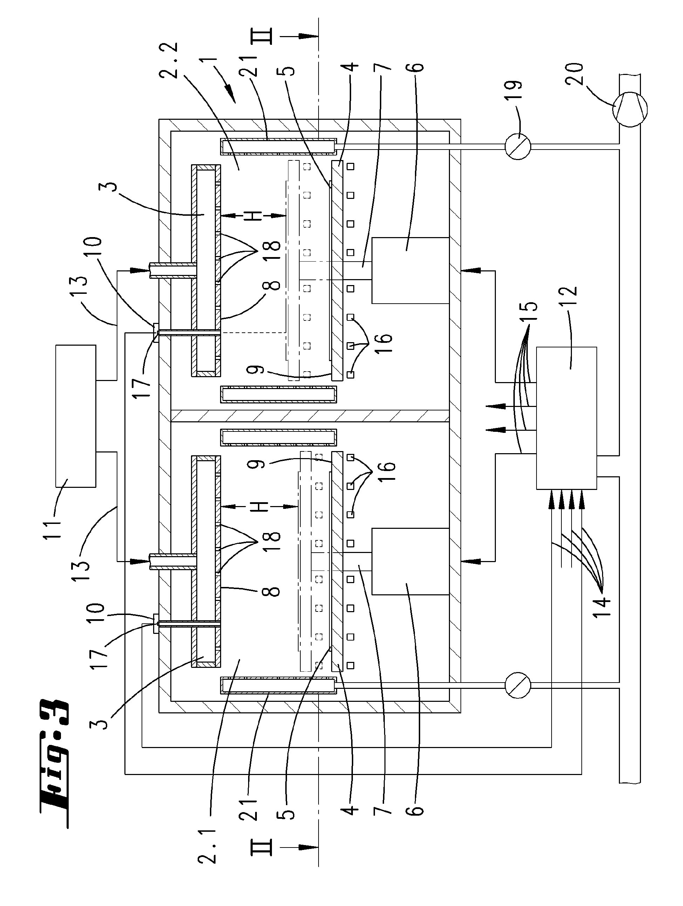

Anders als bei dem in der Fig. 1 dargestellten Ausführungsbeispiel ist bei dem in der Fig. 3 dargestellten Ausführungsbeispiel der optische Sensor 17 außerhalb des Reaktorgehäuses 1 angeordnet. Im dort dargestellten Ausführungsbeispiel sitzt der optische Sensor 17 auf der Reaktorgehäusedecke und ist mit einem Rohr verbunden, welches durch das Gaseinlassorgan 3 hindurchragt. Die Schichtdickenmesseinrichtung 10 besitzt eine Sensorfläche, die in Sichtverbindung mit dem Substrat steht. In der Fig. 3 ist zu jeder Prozesskammer 2.1, 2.2 lediglich nur eine Schichtdickenmesseinrichtung 10 dargestellt. Auch hier können mehrere Schichtdickenmesseinrichtungen vorgesehen sein, um die Wachstumsrate an verschiedenen Positionen des Substrates zu messen.

In einer nicht dargestellten weiteren Version ist anstelle des Rohres ein Lichtleiter vorgesehen, um die optische Verbindung zwischen dem optischen Sensor 17 und der Prozesskammer herzustellen.

In einer weiteren, nicht dargestellten Version ist in der Reaktorwandung lediglich ein optisches Fenster vorgesehen, rückwärtig dessen sich der optische Sensor 17 befindet.

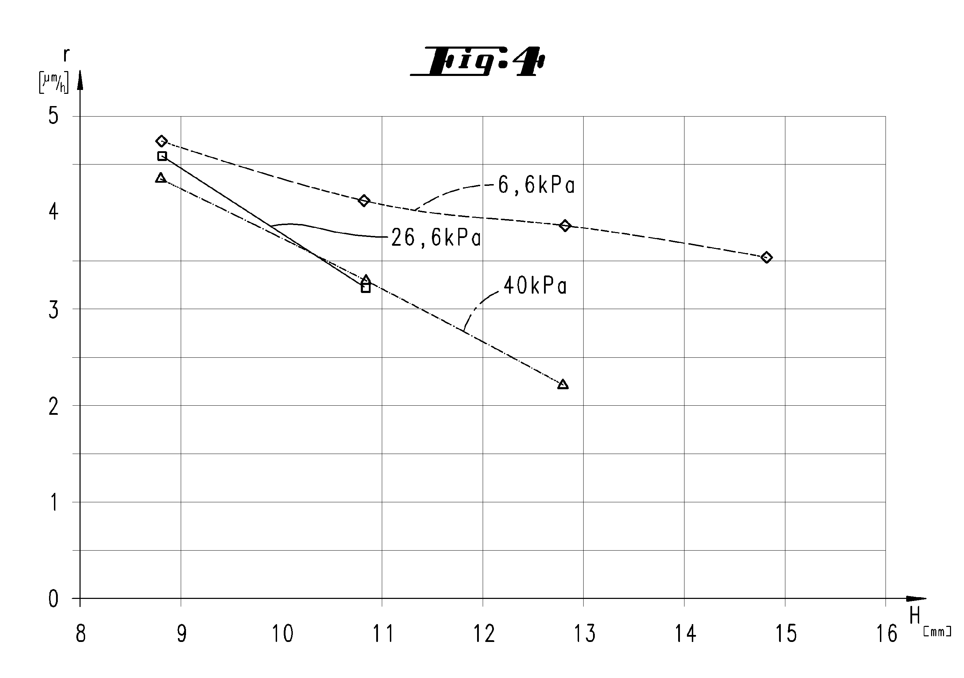

Mit dem erfindungsgemäßen Verfahren und in der erfindungsgemäßen Vorrichtung können Schichten aus GaN, AlGaN, InGaN, GaAs, InP, AlGaAs, In-GaAs etc. abgeschieden werden. Bei einem Abscheidungsprozess, bei dem unter Verwendung von TMGa und NH₃ GaN abgeschieden wird, wurde die Abhängigkeit der Wachstumsrate r von der Prozesskammerhöhe bestimmt. Fig. 4 gibt die diesbezüglichen Messwerte für einen Totaldruck von 6.6 kPa, 26.6 kPa und 40 kPa wieder. Es ist zu erkennen, dass die Wachstumsrate (µm/h) bei hohen Totaldrücken eine größere Abhängigkeit von der Prozesskammerhöhe H (mm) besitzt, als bei niedrigeren Wachstumsraten.

### Bezugszeichenliste

- 1: Reaktorgehäuse, Beschichtungseinrichtung
- 2: Prozesskammer
- 3: Gaseinlassorgan
- 4: Suszeptor
- 5: Substrat
- 6: (Höhen-)Einstellglied
- 7: Träger
- 8: Prozesskammerdecke
- 9: Prozesskammerboden
- 10: Schichtdickenmesseinrichtung
- 11: Gasversorgungseinrichtung
- 12: Regler
- 13: (Gas-) Zuleitung
- 14: Eingangsleitung
- 15: Datenleitung
- 16: Heizung
- 17: optischer Sensor
- 18: (Gasaustritts-)Öffnung
- 19: Druckregler, Druckregeleinrichtung
- 20: Vakuumpumpe
- 21: Gasauslassring

## Patentansprüche

1. Verfahren zum Abscheiden von jeweils mindestens einer Schicht, insbesondere einer Halbleiterschicht auf einer Vielzahl von Substraten (5), wobei in einem Reaktorgehäuse einer Beschichtungsvorrichtung (1) mehrere, Prozesskammern (2) von einer gemeinsamen Gasversorgungseinrichtung (11) mit Prozessgasen versorgt werden, die jeweils von einem Gaseinlassorgan (3) in die Prozesskammer (2) eingeleitet werden, in der sich auf einem Suszeptor (4) ein oder mehrere der zu beschichtenden Substrate (5) befinden, wobei die vom Abstand einer Prozesskammerdecke (8) und einem Prozesskammerboden (9) definierte Prozesskammerhöhe (H) variierbar ist und einen Einfluss auf die Wachstumsrate der Schicht hat, **dadurch gekennzeichnet, dass** während des Schichtwachstums kontinuierlich bzw. in insbesondere kurzen Intervallen in jeder Prozesskammer (2) an zumindest einem Substrat (5) die Schichtdicke gemessen wird und mittels eines Reglers (12) und eines Stellgliedes (6) die Prozesskammerhöhe (H) so variiert wird, dass in den Prozesskammern Schichten mit gleicher Schichtdicke abgeschieden werden.

2. Verfahren nach Anspruch 1, **dadurch gekennzeichnet, dass** die Messung der Schichtdicke mit einer optischen Sensoranordnung (17) erfolgt, die an der Rückwand eines eine Kammer ausbildende Gaseinlassorgans (3) angeordnet ist und die optische Wegstrecke durch jeweils eine Öffnung (18) des Gaseinlassorgans (3) läuft, welches Gaseinlassorgan (3) die Prozesskammerdecke (8) ausbildet.

3. Verfahren nach einem der vorhergehenden Ansprüche 1 oder 2, **gekennzeichnet durch** eine gemeinsame Evakuierungseinrichtung (20) und je einer Prozesskammer (2) individuell zugeordneten Druckregeleinrichtung (19).

4. Verfahren nach einem der vorhergehenden Ansprüche 1, 2 oder 3, **dadurch gekennzeichnet, dass** in den Prozesskammern (2) ein MOCVD-Prozess durchgeführt wird.

5. Vorrichtung zum Abscheiden von mindestens einer Schicht, insbesondere Halbleiterschicht auf eine Vielzahl von Substraten (5), mit einem Reaktorgehäuse (1), das eine Vielzahl von Prozesskammern (2) aufweist, wobei jede Prozesskammer (2) ein Gaseinlassorgan (3) zum Einleiten von Prozessgasen in die Prozesskammer (2) und einen Suszeptor (4) zur Aufnahme mindestens eines Substrates (5) aufweist und wobei die vom Abstand einer Prozesskammerdecke (8) und einem Prozesskammerboden (9) gebildete Prozesskammerhöhe (H) von einem Stellglied (6) einstellbar ist und mit einer gemeinsamen Gasversorgungseinrichtung (11), um die Prozesskammern (2) mit dem Prozessgas zu versorgen, **dadurch gekennzeichnet, dass** jede Prozesskammer (2) eine Schichtdickenmesseinrichtung (10) aufweist, mit der während des Schichtwachstums an zumindest einem Substrat kontinuierlich oder in insbesondere kurzen Intervallen die Schichtdicke der Schicht ermittelbar ist, und dass ein Regler (12) vorgesehen ist, dessen Eingangsgrößen die von den Schichtdickenmesseinrichtungen (10) ermittelten Schichtdicken und deren Ausgangsgrößen Stellwerte für die Stellglieder (6) sind und die momentan gemessenen Schichtdicken miteinander vergleicht, um die Stellglieder mit Stellwerten zu versorgen, um die Prozesskammerhöhe (H) so zu variieren, dass in den Prozesskammern Schichten mit gleicher Schichtdicke abgeschieden werden.

6. Vorrichtung nach Anspruch 5, **gekennzeichnet durch** eine unterhalb des Suszeptors (4) angeordnete, insbesondere mit dem Suszeptor (4) höhenverlagerbare Heizung (16).

7. Vorrichtung nach einem der Ansprüche 5 oder 6, **dadurch gekennzeichnet, dass** die vom Regler (12) an die Stellglieder (6) gegebenen Stellwerte von der von der schichtdicken Messeinrichtung (17) gemessenen Schichtdicke abhängt.

8. Vorrichtung nach einem der vorhergehenden Ansprüche 5, 6 oder 7, **dadurch gekennzeichnet, dass** der Regler (12) so eingerichtet ist, dass durch eine Variation der Prozesskammerhöhe (H) Schichten mit gleicher Schichtdicke abgeschieden werden.

## Claims

1. Method for depositing at least one layer, in particular a semiconductor layer, on a multiplicity of substrates (5), in which, in a reactor housing of a coating apparatus (1), a plurality of process chambers (2), are supplied with process gases by a common gas supply apparatus (11), the gases being introduced into the process chamber (2) by, in each case, a gas inlet member (3), in which chamber one or more of the substrates (5) to be coated are located on a susceptor (4), the process chamber height (H), which is defined by the spacing between a process chamber ceiling (8) and a process chamber floor (9), being variable and influencing the growth rate of the layer, **characterized in that** the layer thickness is measured during the layer growth continuously or at in particular short intervals on at least one substrate (5) in each process chamber (2) and the process chamber height (H) is varied by means of a controller (12) and an adjusting member (6) so that layers with the same layer thickness are deposited in the process chambers.

2. Method according to Claim 1, **characterized in that** the measuring of the layer thickness is effected by an optical sensor arrangement (17), which is disposed on the rear wall of a gas inlet member (3) that forms a chamber and the optical pathway runs through in each case an opening (18) in the gas inlet member (3) that forms the process chamber ceiling (8).

3. Method according to one of the preceding claims 1 or 2, **characterized by** a common evacuation device **(20)** and a pressure regulating device (19) individually associated in each case with one process chamber (2).

4. Method according to one of the preceding claims 1, 2 or 3, **characterized in that** an MOCVD process is carried out in the process chambers (2).

5. Apparatus for depositing at least one layer, in particular a semiconductor layer, on a multiplicity of substrates (5), comprising a reactor housing (1) that has a multiplicity of process chambers (2), each process chamber (2) having a gas inlet member (3) for introducing process gases into the process chamber (2) and a susceptor (4) for receiving at least one substrate (5), and the process chamber height (H), which is defined by the spacing between a process chamber ceiling (8) and a process chamber floor (9), being adjustable by an adjusting member (6), and comprising a common gas supply apparatus (11) for supplying the process chambers (2) with the process gas, **characterized in that** each process chamber (2) has a layer thickness measuring device (10), by which, during the layer growth, the layer thickness of the layer on at least one substrate can be detected continuously or at in particular short intervals, and that a controller (12) is provided, the input values to which are the layer thicknesses detected by the layer thickness measuring devices (10) and the output values of which are setting values for the adjusting members (6)and compares the currently measured layer thicknesses with one another, in order to supply the adjusting members with setting values, in order to vary the process chamber height (H) to the effect that layers with the same layer thickness are deposited.

6. Apparatus according to Claim 5, **characterized by** a heater (16) disposed beneath the susceptor (4), the heater being in particular movable as to height with the susceptor (4).

7. Apparatus according to one of the Claims 5 or 6, **characterized in that** the setting values delivered by the controller (12) to the adjusting members (6) are dependent on the layer thickness measured by the layer thickness measuring device (17).

8. Apparatus according to one of the preceding Claims 5, 6 or 7, **characterized in that** the controller (12) is arranged so that by a variation of the process chamber height (H), layers having the same layer thickness are deposited.

## Revendications

1. Procédé pour déposer au moins une couche, plus particulièrement une couche de semi-conducteur sur une pluralité de substrats (5), plusieurs chambres de traitement (2) étant alimentées par un dispositif commun d'alimentation en gaz (11), dans un boîtier de réacteur d'un dispositif d'approvisionnement (1), en gaz de traitement qui sont introduits par un organe d'admission de gaz (3) dans la chambre de traitement (2), dans laquelle se trouvent, sur un suscepteur (4), un ou plusieurs substrats (5) à revêtir, la hauteur de la chambre de traitement (H), définie par la distance entre un plafond de chambre de traitement (8) et un fond de chambre de traitement (9) étant variable et ayant une influence sur le taux de croissance de la couche, **caractérisé en ce que**, pendant la croissance de la couche, l'épaisseur de la couche est mesurée continuellement ou plus particulièrement à de brefs intervalles dans chaque chambre de traitement (2) sur au moins un substrat (5) et, à l'aide d'un régulateur (12) et d'un organe de réglage (6), la hauteur de la chambre de traitement (H) est modifiée de façon à ce que, dans les chambres de traitement, des couches de même épaisseur sont déposées.

2. Procédé selon la revendication 1, **caractérisé en ce que** la mesure de l'épaisseur de la couche a lieu avec un dispositif à capteurs optiques (17), qui se trouve sur la paroi arrière d'un organe d'admission de gaz (3) formant une chambre et le trajet optique s'étend à travers une ouverture (18) de l'organe d'admission de gaz (3), cet organe d'admission de gaz (3) constituant le plafond de la chambre de traitement (8).

3. Procédé selon l'une des revendications précédentes 1 ou 2, **caractérisé par** un dispositif d'évacuation commun (20) et un dispositif de régulation de pression (19) correspondant individuellement à chaque chambre de traitement (2).

4. Procédé selon l'une des revendications précédentes 1, 2 ou 3, **caractérisé en ce que**, dans les chambres de traitement (2), un traitement MOCVD est réalisé.

5. Dispositif pour déposer au moins une couche, plus particulièrement une couche de semi-conducteur sur une pluralité de substrats (5), avec un boîtier de réacteur (1), qui comprend une pluralité de chambres de traitement (2), chaque chambre de traitement (2) comprenant un organe d'admission de gaz (3) pour l'introduction de gaz de traitement dans la chambre de traitement (2) et un suscepteur (4) pour le logement d'au moins un substrat (5) et la hauteur de la chambre de traitement (H), définie par la distance entre un plafond de chambre de traitement (8) et un fond de chambre de traitement (9), étant réglable à l'aide d'un organe de réglage (6) et devant être alimenté avec un dispositif d'alimentation en gaz commun (11) afin d'alimenter les chambres de traitement (2) en gaz de traitement, **caractérisé en ce que** chaque chambre de traitement (2) comprend un dispositif de mesure d'épaisseur de couche (10) avec lequel, pendant la croissance de la couche, sur au moins un substrat, l'épaisseur de la couche est mesurée continuellement ou plus particulièrement à de brefs intervalles et ce qu'un régulateur (12) est prévu, dont les grandeurs d'entrée sont les épaisseurs de couches déterminées par les dispositifs de mesure d'épaisseur de couches (10) et dont les grandeurs de sortie sont des valeurs de réglage pour les organes de réglage (6), et compare les épaisseurs de couches actuellement mesurées entre elles afin d'alimenter les organes de réglages en valeurs de mesure, afin de faire varier la hauteur de la chambre de traitement (H) de façon à ce que, dans les chambres de traitement, des couches de même épaisseur soient déposées.

6. Dispositif selon la revendication 5, **caractérisé par** un chauffage (16) disposée en dessous du suscepteur (4), plus particulièrement mobile en hauteur avec le suscepteur (4).

7. Dispositif selon l'une des revendications 5 ou 6, **caractérisé en ce que** les valeurs de réglage transmises par le régulateur (12) aux organes de réglage (6) dépendant de l'épaisseur de couche mesurée par le dispositif de mesure d'épaisseur de couche (17).

8. Dispositif selon l'une des revendications 5, 6 ou 7, **caractérisé en ce que** le régulateur (12) est conçu de façon à ce qu'une variation de la hauteur de la chambre de traitement (H) permette de déposer des couches de même épaisseur.
